# EUROPEAN PATENT SPECIFICATION

(11) **EP 0 307 726 B1**
(45) Date of publication and mention of the grant of the patent: **06.12.1995**
(21) Application number: 88114258.2
(22) Date of filing: 01.09.1988
(51) Int. Cl.: G03F 1/00

(54) **Semiconductor manufacturing process which compensates for the distortion between a pattern on a semiconductor body and the mask from which the pattern is derived**
Prozess zur Herstellung von Halbleitern, bei dem die Bildverzeichnung zwischen dem Muster auf der Halbleiteroberfläche und der dieses erzeugenden Maske kompensiert wird
Procédé pour la fabrication de semi-conducteur avec compensation de la distorsion de l'image sur la surface du semi-conducteur et de l'image sur le masque

(30) Priority: 14.09.1987 US 95808
(43) Date of publication of application: 22.03.1989
(73) Proprietor: MOTOROLA INC., Schaumburg Illinois 60196 (US)
(72) Inventor: Morton, Bruce L., Round Rock Texas 78681 (US); Harris, Sarah T., Houston Texas 77025 (US); Gerosa, Gianfranco, Coconut Creek Florida 33066 (US)
(74) Representative: Ibbotson, Harold

(56) References cited:
- PATENT ABSTRACTS OF JAPAN vol. 9, no. 280 (E-356)(2003) 08 November 1985 & JP-A- 60 124822

## Description

### Field of the Invention

The present invention relates to manufacturing processes for semiconductors, and more particularly, to semiconductor manufacturing processes which use masks for patterning the exposure of radiation-sensitive material on a semiconductor body.

### Background of the Invention

It is standard for a mask to be used in obtaining a desired pattern on a semiconductor body for the purpose of obtaining a desired semiconductor circuit. The desired circuit is obtained from a series of patterning and processing steps. A mask is used for each patterning step. A mask set for a circuit comprises all of the masks necessary for the patterning steps. After a patterning step, there is normally a processing step which removes or adds material according to the pattern.

Prior to actually patterning the semiconductor body there is first applied thereto a radiation-sensitive material, commonly known as photoresist. Radiation is applied to selected portions of the photoresist according to the pattern of the mask using lithographic equipment resulting in an after-exposure pattern in the photoresist on the semiconductor body. The intent is to expose the photoresist in precisely the same pattern as the pattern of the mask so that the after-exposure pattern and the mask pattern are identical. After the photoresist has been exposed using the mask, photoresist is removed according to the exposure. Depending on the nature of the photoresist that was applied, either the exposed portion is removed or the unexposed portion is removed. Photoresist that has its exposed portion removed is generally known as "positive resist," and photoresist that has its unexposed portion removed is known as "negative resist." After removing the photoresist according to the exposure thereof, there is then processing applied to the semiconductor body which operates on the portion from which the photoresist has been removed. For example, silicon may be immediately under the photoresist so that where the photoresist has been removed the silicon can be processed. One possibility is that an etchant may be introduced which removes silicon in the areas where the photoresist has been removed. Whatever the process step, there will be a resulting after-processing pattern on the semiconductor body which was determined by the mask. There will, however, be some distortion introduced by the lithographic equipment and the processing so that there will be some differences between the after-processing pattern and the mask pattern.

That there is a difference between the after-processing pattern and the mask pattern is known. To the extent this has presented a significant problem, some level of correction has been achieved by trial and error. Although there is generally going to be a limit on the extent of the correction because of limits on the resolution of the equipment which makes the mask, some correction is possible by altering the mask pattern to compensate for distortion introduced by the processing steps and the lithographic equipment. The designer of the mask then changes the mask pattern in each of the locations where compensation is recognized as being desirable according to an estimate as to what will provide the optimum resulting after-processing pattern. This altering of the mask pattern can be optimized by experiments using the trial and error method.

There are several disadvantages to this approach. Generating a mask set for each experiment is costly and time consuming. The subsequent processing of the semiconductor body can also be quite time consuming. This aspect may well result in going forward with a distortion compensation which is not in fact optimized. Each location where compensation is to be provided must be identified and entered by the designer. If the process is improved so that there is less distortion introduced by the process, the compensation on the mask may be too great and actually result in lower performance of the resulting circuit or lower yield. The same may occur for improvements in the lithographic equipment. Also, it is common to "shrink" the die size of an integrated circuit as processing geometries are reduced in light of technological improvements. The dimensions of the mask pattern are accordingly shrunk. The distortion may not shrink in the same proportion as the other geometries. There are thus several likely ways that the distortion may change. In such a case each part of the mask pattern which had compensation may then need to be changed by the designer. Of course the original designer of the mask may not be available for this purpose so that the original purpose for the compensation may not be well known or fully understood. Also it may not be clear where all of the compensation locations are.

JP-A-60-124822 relates to the issue of anticipating certain distortions which occur in processing of a wafer. Correction data is produced by having a simulation for every patttern.

### Summary of the Invention

An object of the present invention is to provide an improved semiconductor manufacturing process.

Another object of the invention is to provide an improved process for obtaining a desired pattern on a semiconductor body.

Yet another object of the invention is to provide an improved semiconductor manufacturing technique for compensating for the distortion between a pattern on a mask and the resulting pattern provided on a semiconductor body.

These and other objects are achieved in a semiconductor manufacturing process in which a mask is patterned in a manner to compensate for distortion in performing patterning of processing a wafer. The distortion which occurs during processing is represented by a distortion function. The inverse distortion function is used for convolving with estimated patterns to obtain predictions of wafer patterns after processing. This can be repeated with other estimated patterns as a trial and error approach to select the estimated pattern which results in a pattern on the wafer which most closely approximates a desired pattern. The selected estimated pattern is then used to pattern a mask. The mask is then used in the process to obtain a resulting pattern which closely approximates the desired pattern.

### Brief Description of the Drawings

FIG. 1 is a block diagram of a system for implementing the process of the invention;
FIG. 2 is a process flow of the invention in one embodiment of the invention; and
FIG. 3 is a process flow of the invention in a second embodiment of the invention.

### Description of the Invention

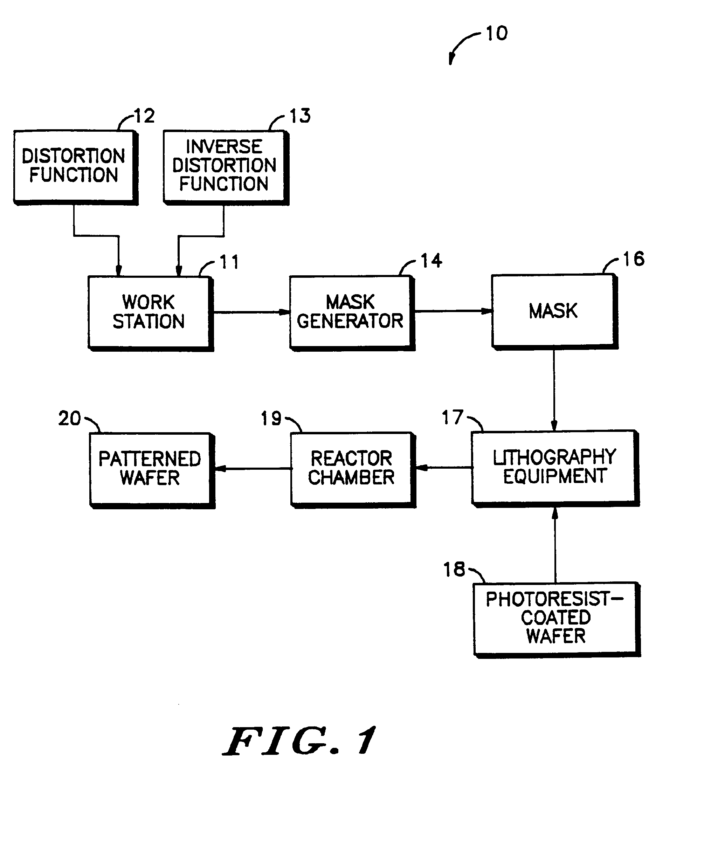

Shown in FIG. 1 is a system 10 comprised generally of a work station 11 for using a distortion function 12 and an inverse distortion function 13, a mask generator 14, a mask 16, lithography equipment 17, a photoresist-coated wafer 18, a reactor chamber 19, and a patterned wafer 20. Work station 11 is for use by a designer of integrated circuits. The designer inputs information descriptive of a desired pattern on a semiconductor body into work station 11. The work station interprets this input and provides information representative of this input to mask generator in a form from which mask generator 14 can produce mask 16. Mask 16 is then used by lithography equipment 17 to selectively expose portions of photoresist-coated wafer 18. Reactor chamber 19 is then used to act on photoresist-coated wafer 18 to produce patterned wafer 20. Patterned wafer 20 contains many semiconductor die each of which have virtually identical patterns etched, deposited, and/or grown on the semiconductor body thereof. Mask 16 contains repetitive patterns for the die. At present there are two common approaches to exposing a wafer which has been coated with photo-resist, the stepper approach and a projection approach. In the stepper approach, which is more precise than the projection approach, only several of the die locations are simultaneously exposed so that the mask in such a case repeats the pattern only the several times. In the projection approach all of the die are simultaneously exposed so that the mask in such case contains the die pattern repeated all of the times that the die appear on the wafer. In either case, the pattern that is of concern is the individual die pattern.

In the semiconductor manufacturing process of system 10 the individual die pattern varies from step to step. The designer inputs a design which is desired on the wafer which has been processed. Thus the desired pattern is the pattern that the designer would like to see as a finished pattern which is the pattern on each die of the patterned wafer. There is a difference between the mask pattern and the finished pattern because of distortions introduced by lithography equipment 17 and processing in reactor chamber 19. This distortion between the mask pattern and the finished pattern is characterized by distortion function 12 from which inverse distortion function 13 is derived. The designer inputs the desired pattern into work station 11 and then convolves the inverse distortion function with the desired pattern. This convolution is performed by work station 11. This convolved pattern is then input to mask generator 14 which then produces mask 16 with the convolved pattern. Mask 16 then is used to expose photoresist-coated wafer 18 to produce an exposure pattern which is distorted from the mask pattern in an amount determined by the lithographic process. Photoresist-coated wafer 18 is subsequently processed using reactor chamber 19 to produce patterned wafer 20 which then has the finished pattern on each of the die thereof. The portion of the process in which material is grown on, etched from, and/or deposited on the semiconductor body of each die using reactor chamber 19 provides an additional amount of distortion which, when added to the lithography equipment distortion, provides the distortion represented by distortion function 12. The result of the process using system 10 is that the desired pattern is the same as the finished pattern or approximately so.

A limitation in the ability to ensure that the finished pattern is the same as the desired pattern is the limitations in the resolution of the mask generator. Typically, the designer is constrained to making straight lines between points on a matrix. Thus, in a situation in which a curve is desired, the curve must be approximated by using short straight lines. Further, straight lines are approximated as a sequence of juxtaposed pixels in the mask generator. The pattern is made by selectively exposing the pixels in a raster scanner type approach. There is a limitation as to how short the lines can be. For example, in a typical state of the art mask generator, such as a Perkin-Elmer MEBES III, the smallest pixel that can be resolved is 0.1 micron. Applying inverse distortion function 13 results in a pattern which must be approximated in order to be useable by mask generator 14. Thus the resulting mask pattern is not precisely the same as the true inverse distortion convolved with the desired pattern. The finished pattern differs from the desired pattern due to the inability of the mask generator to accurately put the pattern generated as a result of convolving the desired pattern with inverse distortion function 13 on a mask. Thus in addition to convolving inverse distortion function 13 with the desired pattern, work station 11 also approximates this convolved result according to the capabilities of mask generator 14. This approximation will vary with the capabilities of mask generator 14. These approximation techniques, as well the techniques for obtaining an inverse distortion function from a distortion function and convolving a pattern with some distorting function, are all techniques of the prior art. This approach of using the inverse distortion function to derive the mask pattern from the desired pattern is referred to herein as the direct derivation approach.

Another way to use system 10 is to use distortion function 12 as a quick way to see the finished pattern from a given mask pattern. The mask pattern thatwill result from an input from workstation 11 can be displayed by work station 11 and observed by the designer. The designer can then make estimates as to what the mask pattern should be in order to obtain the desired pattern as the finished pattern. The designer enters an estimated pattern into work station 11 and convolves it with distortion function 12. This results in a prediction of the finished pattern. The designer can then determine how close to the desired pattern the finished pattern will be if the estimated pattern is the mask pattern. The designer can use this tool to experiment with any number of estimated patterns. The designer can then select the estimated pattern which provides the finished pattern which most closely approximates the desired pattern. After selecting the estimated pattern which most closely approximates the desired pattern, mask generator 14 generates mask 16 with a mask pattern which is the selected estimated pattern. The semiconductor process using lithography equipment 17 and reactor chamber 19 then distorts the mask pattern to provide patterned wafer 20 with a pattern which closely approximates the desired pattern.

This trial and error approach may not need to be used for the entire die pattern but for just a critical portion thereof. In a memory, for example, cell density is very important so that the cell is laid out with extreme care. The cell is laid out in such a way as to maximize density while retaining sufficient performance as required for overall circuit performance of the memory. The cell layout is a pattern which is distorted by the semiconductor manufacturing process. The designer begins with a desired pattern for the finished pattern of the cell layout. The designer then estimates what the mask pattern of the cell layout must be in order to obtain the desired pattern as the finished pattern. The cell-layout pattern is convolved with distortion function 12 in order to obtain a convolved cell layout pattern which is a prediction of the finished cell layout pattern. Different estimates of the cell-layout pattern can be convolved with distortion function 12 until the designer is satisfied that the closest possible estimate has been found. The closest estimate of the cell-layout pattern can then be entered into the overall circuit pattern. This approach is particularly convenient because the cell layout is repeated throughout an array. All of the cells can be derived from a single layout. Sometimes the repeated pattern is actually two cells or four cells but each cell in such a case is just a mirror image of another adjoining cell. Thus the entire memory cell array can be laid out easily once a single cell layout has been optimized. This approach of only optimizing a critical portion has an advantage because it can conveniently be implemented using a separate computer from the computing capability resident in work station 11. Estimates of just the cell layout can be entered into the other computer with a relatively small amount of effort. In the other computer, the estimated patterns are convolved with distortion function 12 to obtain predicted finished patterns. After determining which predicted finished pattern most closely approximates the desired pattern, the corresponding estimated pattern is entered into work station 11 for defining a particular critical portion of the overall integrated circuit pattern.

Distortion function 12 mathematically relates the mask pattern to the finished pattern. To obtain distortion function 12 as a mathematical representation which can be used by a computer, both a mask pattern and a consequent finished pattern are first represented mathematically in real space. There are known techniques for making this mathematical representation. The very nature of work station 11 requires that work station 11 make mathematical representations of real-space patterns. The mathematical representation of the finished pattern is deconvolved with the mathematical representation of the mask pattern. Although deconvolution computations are known, they can be extraordinarily long calculations, even for a sophisticated computer. One known approach to performing deconvolution is to perform a Fourier transform on the real-space mathematical representations and then divide the resulting Fourier transforms. Performing the inverse transform on the result of the division results in the distortion function. The mathematical form of the distortion function is, of course, desirably in a form which is useable for being convolved with the mathematical representation of the mask pattern. Thus it is desirable to choose a mathematical form which is consistent with the form that is used for representing the mask pattern in work station 11.

A convenient mathematical form to use is to characterize the mask pattern as being on X-Y axes. For any discrete location defined by X-Y coordinates, the particular location is either within the pattern or outside the pattern. The mask pattern is within a certain range of X and Y coordinates. The mask pattern is then defined in real space by representing each location in the range of X-Y coordinates as being either within or without the pattern. The resolution of the mathematical representation is then dependent on how far apart adjacent coordinates are. For a memory cell pattern that is in a 20 micron by 20 micron range, the coordinates are chosen to be, for example, 0.1 micron apart. The mask pattern is then represented by 200x200 = 40000 X-Y coordinate locations. The finished pattern is represented in the same way as 40000 X-Y coordinates each represented as being either within or outside the finished pattern. Both patterns are thus represented in discrete form to which a discrete Fourier transform is applied. How to perform the discrete Fourier transform is known. The result of performing the discrete Fourier transform on the real-space mathematical representation of both the mask and finished patterns is a discrete frequency-space representation of both patterns. The discrete frequency-space representation of the finished pattern is divided by the discrete frequency-space representaion of the mask pattern. The result is a discrete frequency-space representation of distortion function 12. Taking the inverse discrete Fourier transform thus results in distortion function 12 as a mathematical representation in real space in discrete form. Inverse distortion function 13 can also similarly be obtained by reversing the division, i.e., by dividing the discrete frequency-space representation of the mask-pattern by the discrete frequency-space representation of the finished pattern, and then taking the inverse discrete Fourier transform of the result of the division.

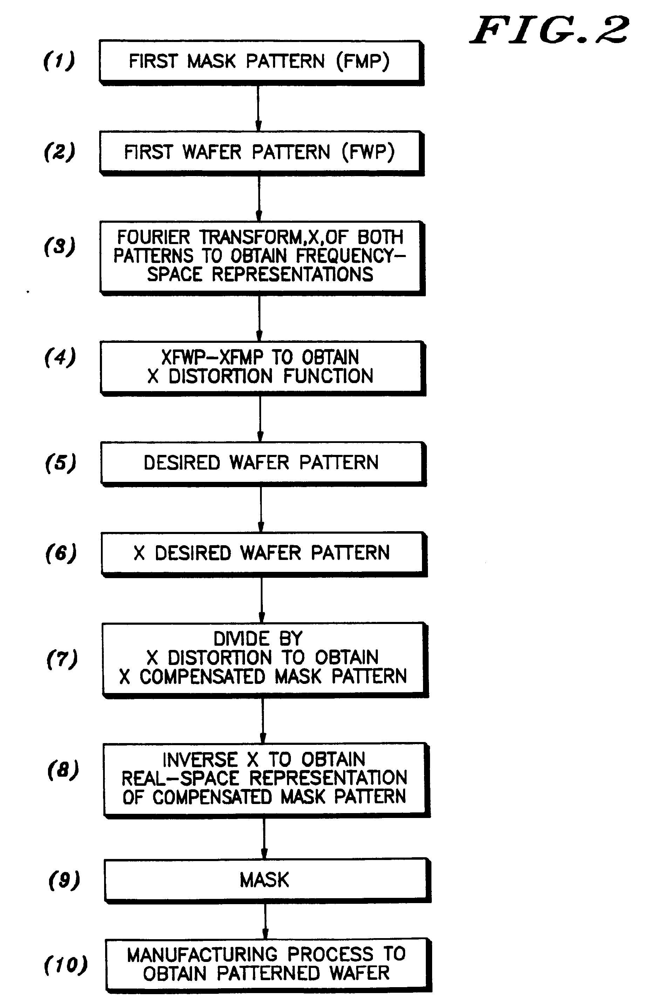

Shown in FIG. 2 is a process flow for implementing the direct derivation approach of generating a mask using Fourier transform techniques. First and second steps are to enter a first mask pattern (FMP) and a first wafer pattern (FWP) derived therefrom. Both are Fourier transformed in a third step. In a fourth step the Fourier transform of the FWP is divided by the Fourier transform of the FMP. This results in obtaining a frequency-space representation of a distortion function. A desired pattern for a finished wafer is entered in a fifth step. The Fourier transform of this desired pattern is then performed in a sixth step to obtain its frequency-space representation. The frequency-space representation of the desired pattern is then divided by the frequency-space representation of the distortion function to obtain the frequency-space representation of a compensated mask pattern in a seventh step. In an eighth step the inverse transform is performed to obtain the compensated mask pattern. A mask, which contains a pattern which is or closely approximates the compensated mask pattern, is then generated in a ninth step. A manufacturing process which incidentally includes the distortion is then, in a tenth step, applied to a semiconductor wafer to obtain a pattern thereon which is or closely approximates the desired pattern.

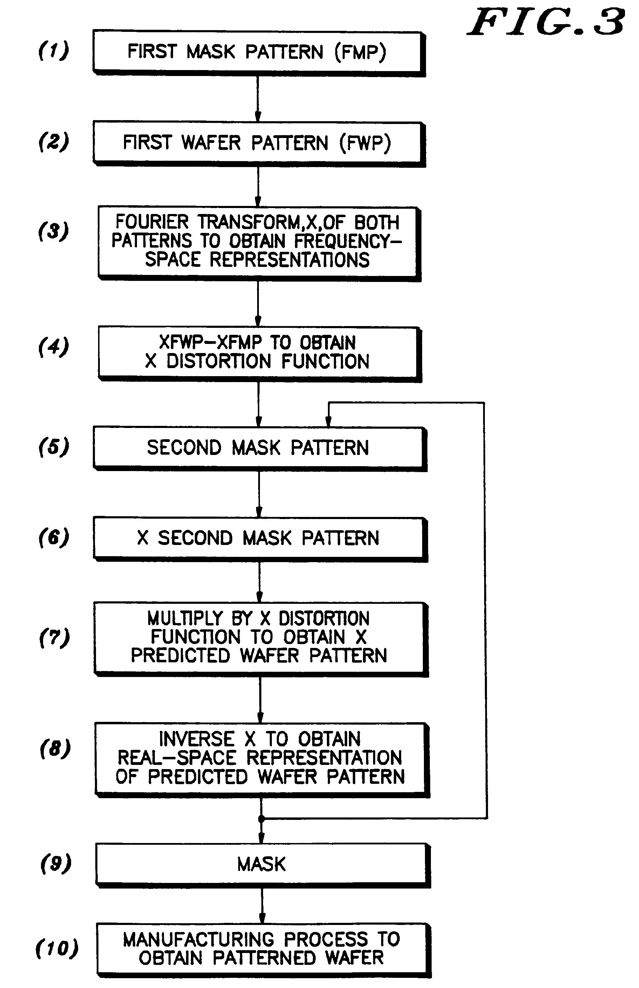

Shown in FIG. 3 is a process flow for implementing the trial and error approach using Fourier transform techniques. The first four steps are the same as for the process flow of shown in FIG. 2. In step 5 a second mask pattern is entered which is an estimate of the optimum mask pattern. In a sixth step the Fourier transform of the second mask pattern is performed to obtain its frequency space representation. In a seventh step the frequency-space representation of the second pattern is multiplied by the frequency-space representation of the distortion function to obtain the frequency-space representation of a predicted wafer pattern. An eighth step takes the inverse transform to obtain the predicted wafer pattern. Steps 5 through eight are repeated substituting new estimated patterns for the second pattern shown in step 5. The steps are reiteratively performed until there is satisfaction that the estimated pattern has been found which results in a predicted pattern which most closely can achieve the desired pattern on a semiconductor wafer. After the particular estimated pattern has been selected, a mask reflecting this selected pattern is generated in step nine. This mask is then used for patterning a semiconductor wafer as part of a manufacturing process which, among other things, causes the distortion represented by the distortion function. This results in the semiconductor wafer, after this processing, having a pattern which closely approximates the desired pattern.

Distortion function 12 which is derived in this manner was experimentally shown to be very accurate in predicting the finished pattern from the mask pattern as applied to a memory cell layout. Distortion function 12 was simplified to a circle which was experimentally shown to be just as accurate in predicting the finished pattern from the mask pattern. It is inherent in the discrete form of mathematical representation that there be some inaccuracy, and it is thus expected that this inaccuracy is what caused the calculated distortion function to be different than a circle. The particular diameter of the distortion circle that yields that most accurate prediction was obtained experimentally. Lithography equipment 17 includes optical equipment with a particular line width resolution capability. It is expected that the contribution to the diameter of the distortion circle comes from processing in reactor chamber 19 and processing from the lithography equipment 17. The contribution from lithography equipment 17 to the diameter of the distortion circle used as distortion function 12 is directly related to the line width resolution of lithography equipment 17. This then also provides some utility in predicting the effect of using lithography equipment with a different line width resolution. It is also expected that a circle is the typical distorting function in the typical approaches to manufacturing semiconductors. Accordingly, a circle can be immediately tried as the distorting function withoutthe need for calculating it. Appendix I is a listing of a program for performing the convolution of an estimated pattern with a distortion function in which the distortion function is a circle. This particular listed program performs the convolution without transforming to frequency space. This is practical because the distortion used is simply a circle. Shown in Appendix II is a listing of a program for performing the convolution of a pattern with a distortion function using the Fourier transform approach. The Fourier transform approach is considered more desirable for the general solution which may be quite complex. The listed programs are in a high level language, BASIC, which is well known.

While the invention has been described in particular embodiments, it will be apparent to those skilled in the art that the disclosed invention may be modified in numerous ways and may assume many embodiments other than those specifically set out and described above. Accordingly, it is intended by the appended claims to cover all modifications of the invention which fall within the true spirit and scope of the invention.

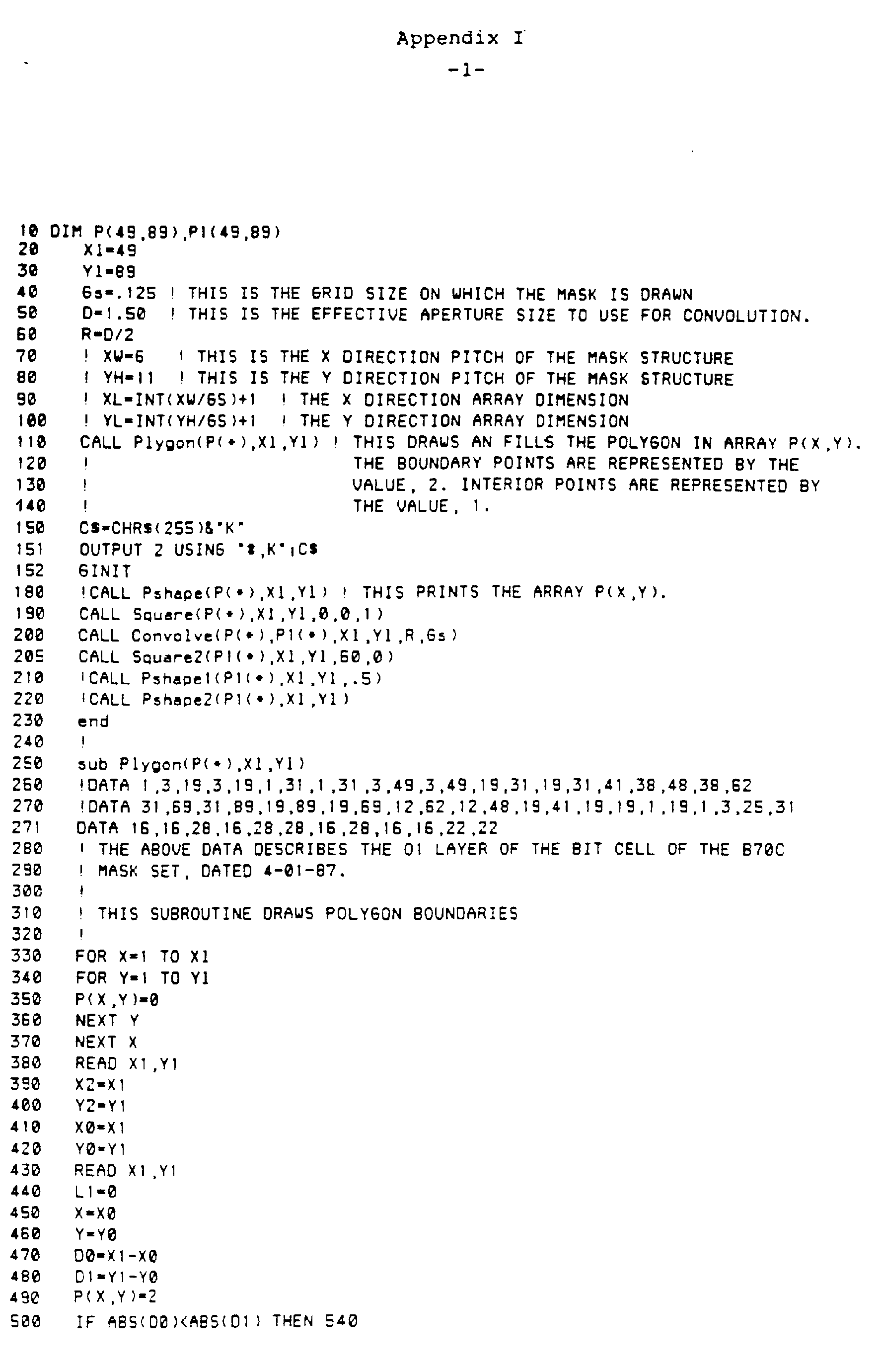

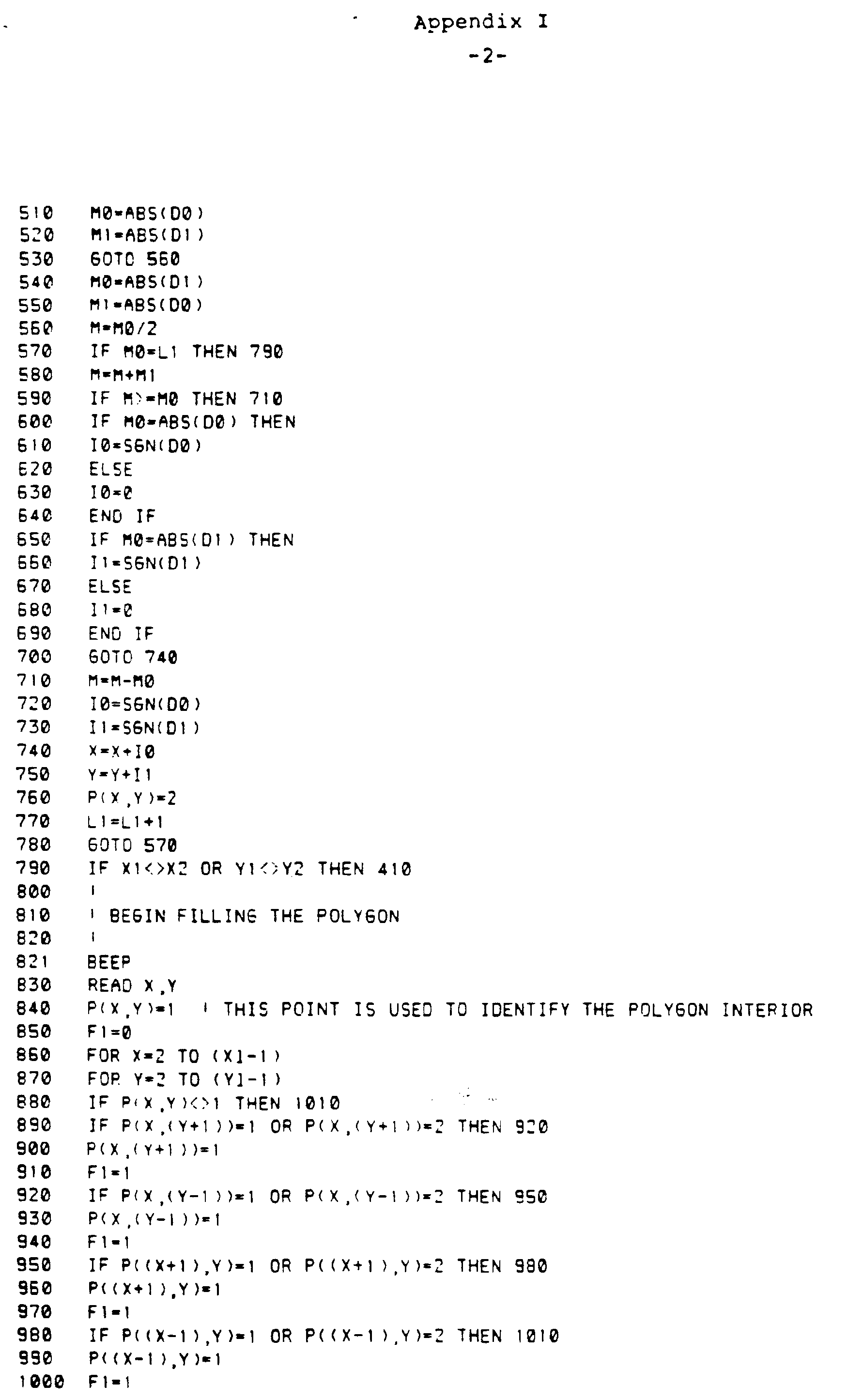

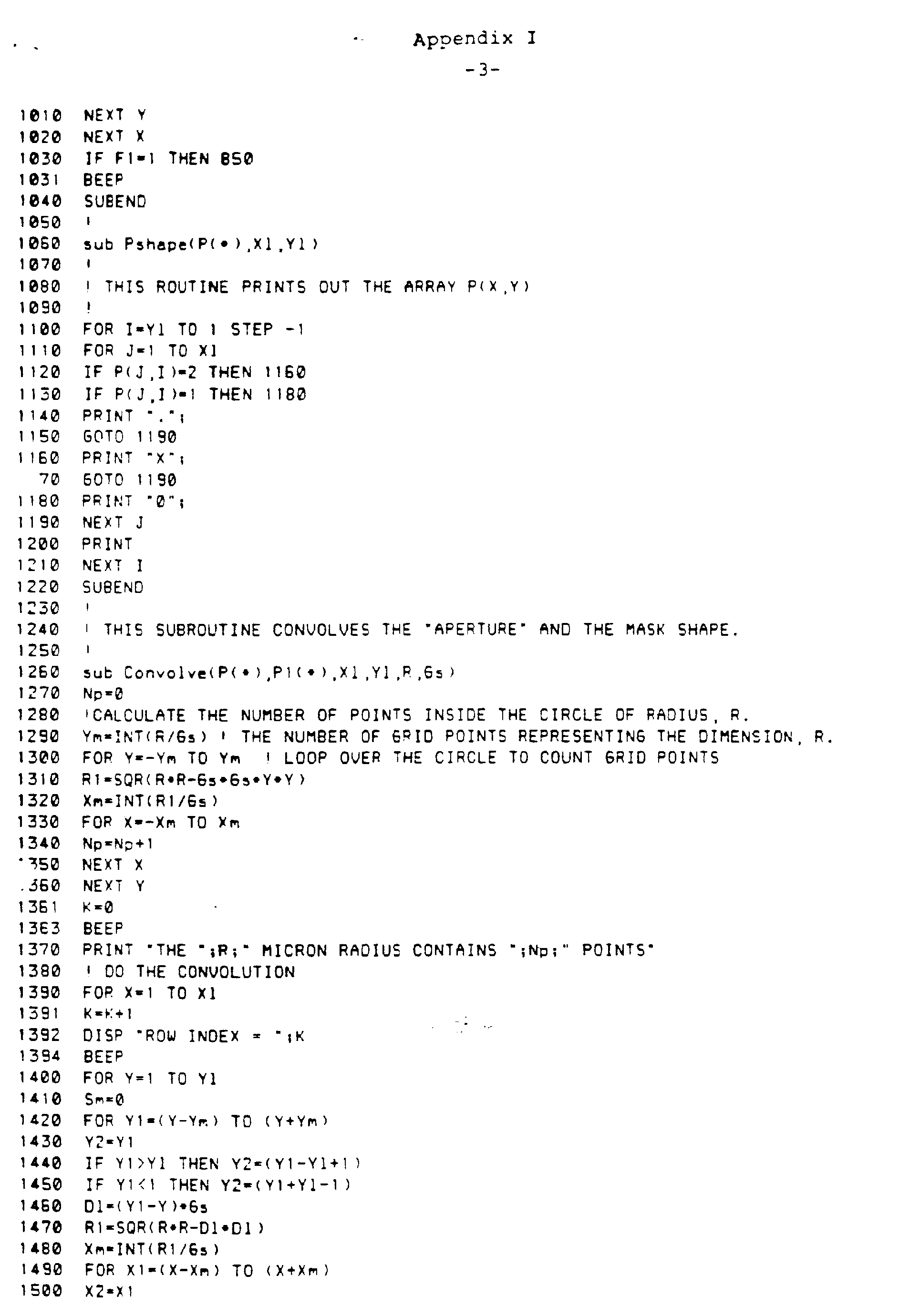

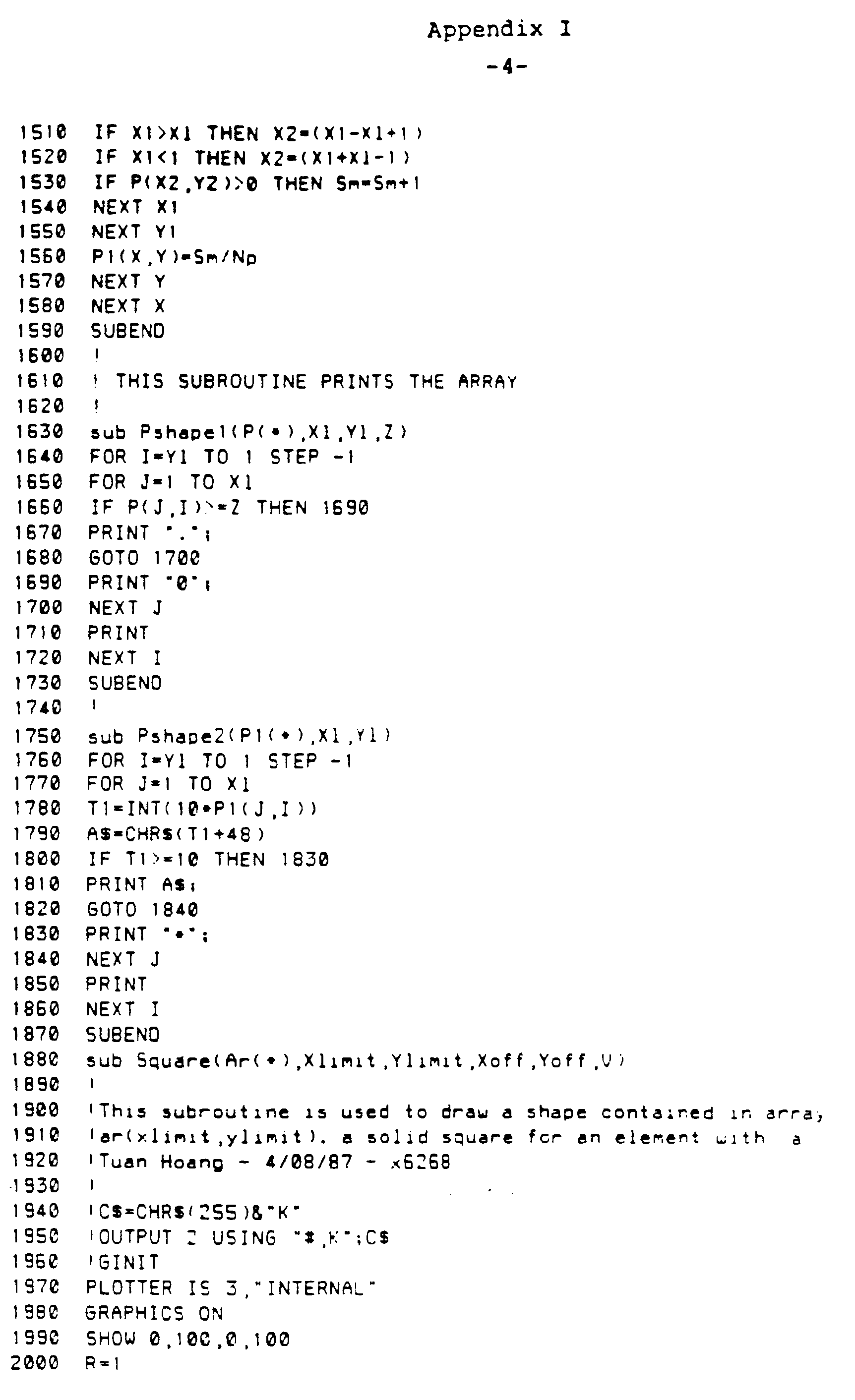

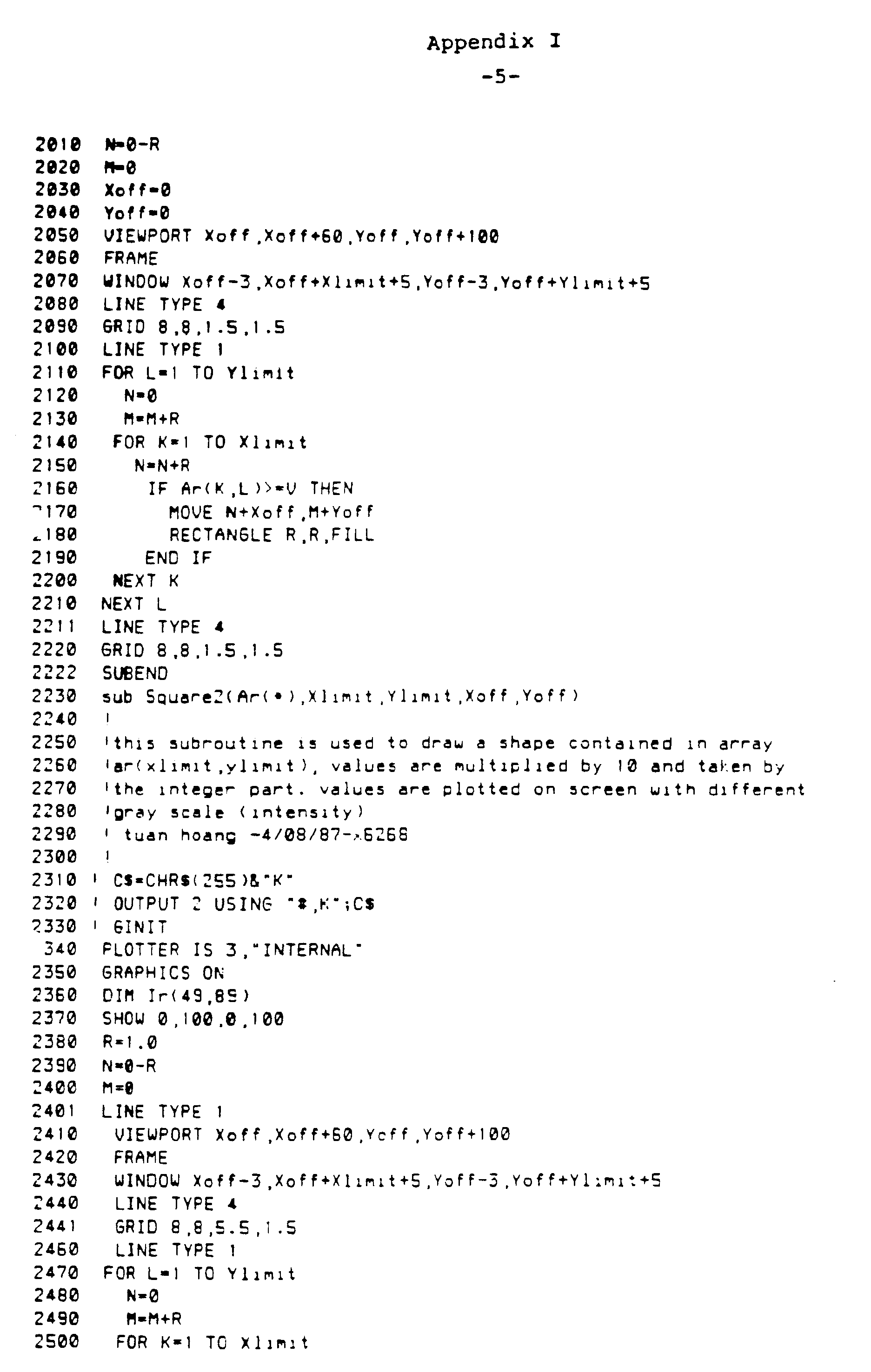

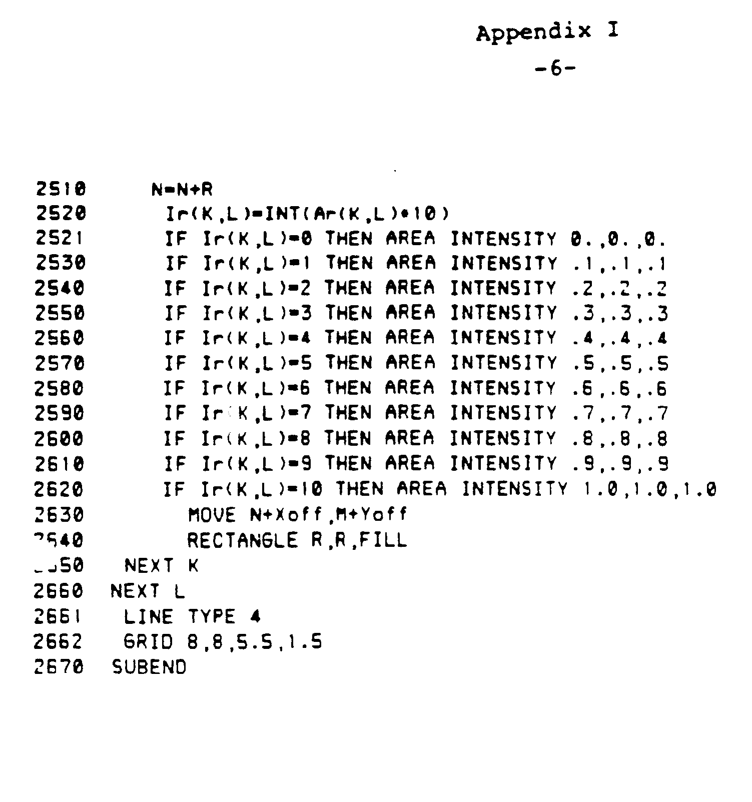

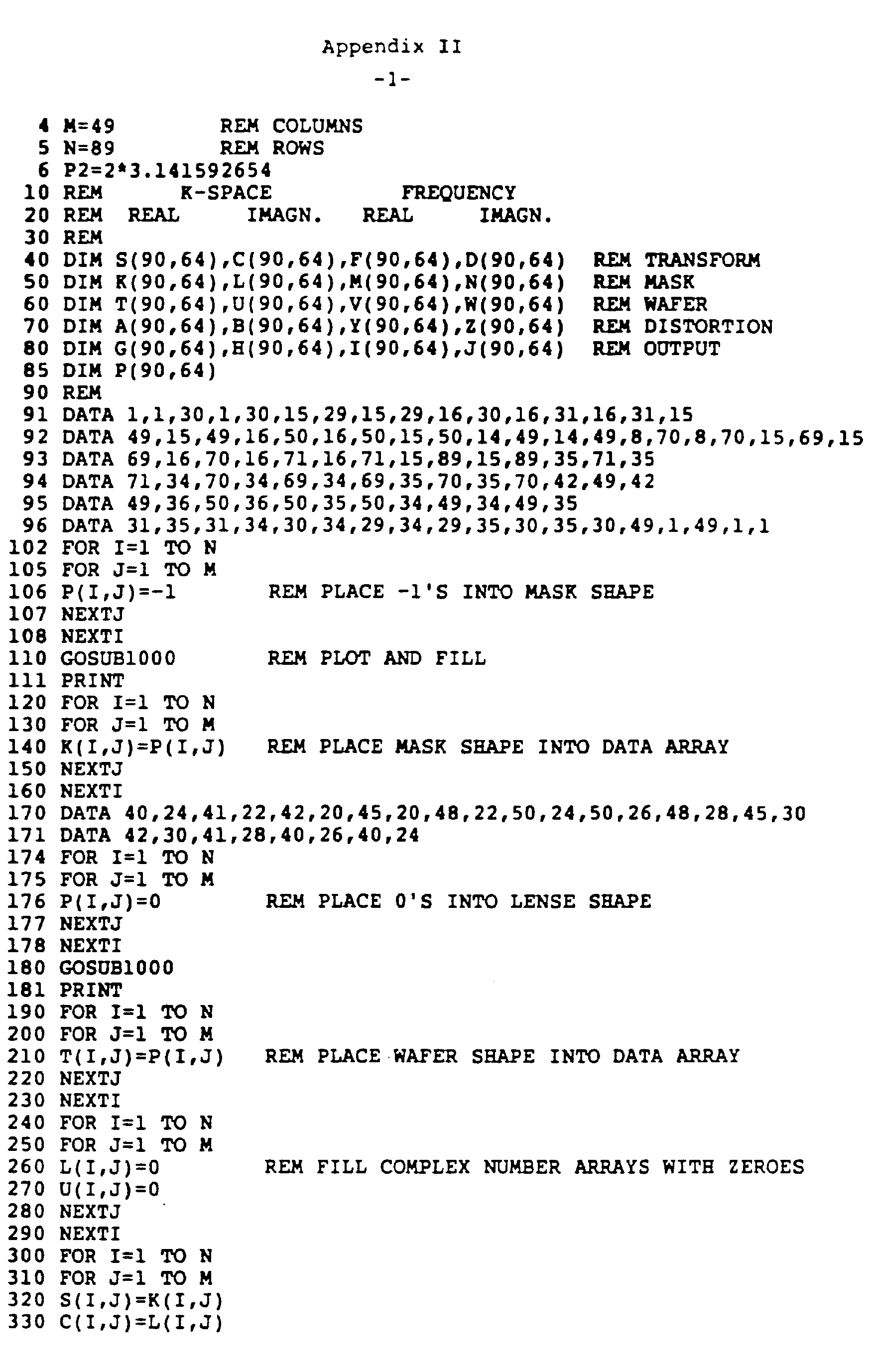

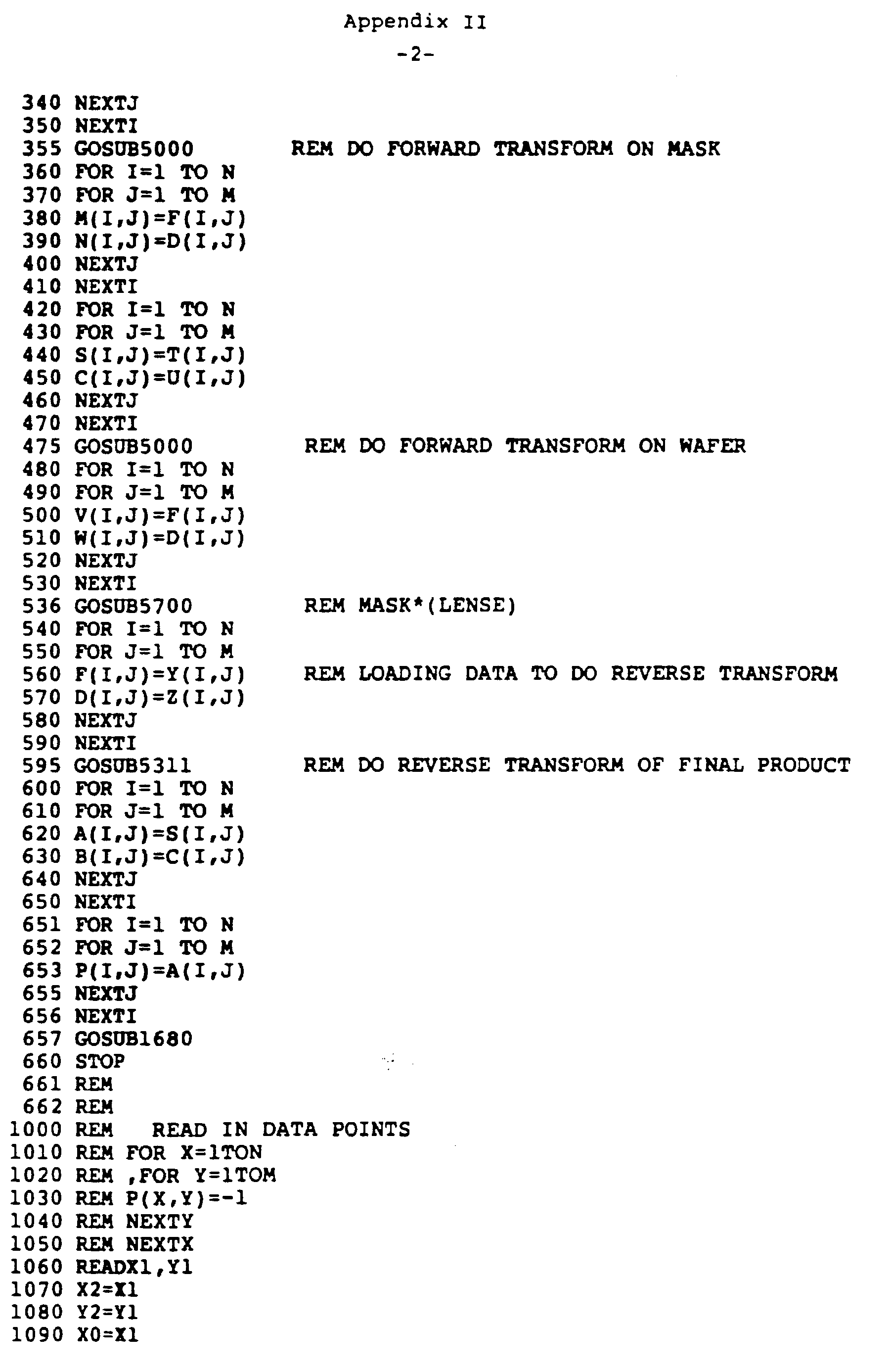

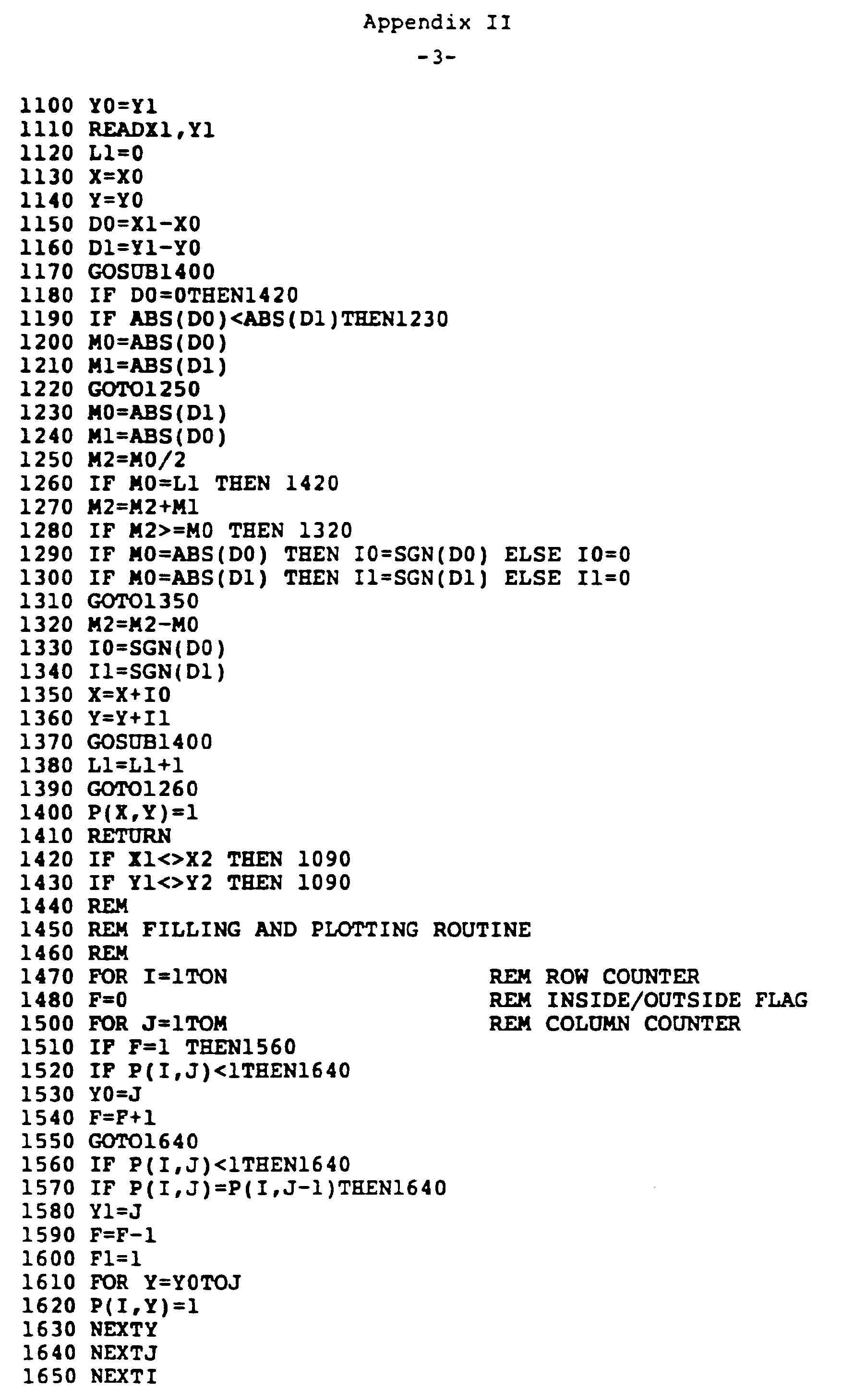

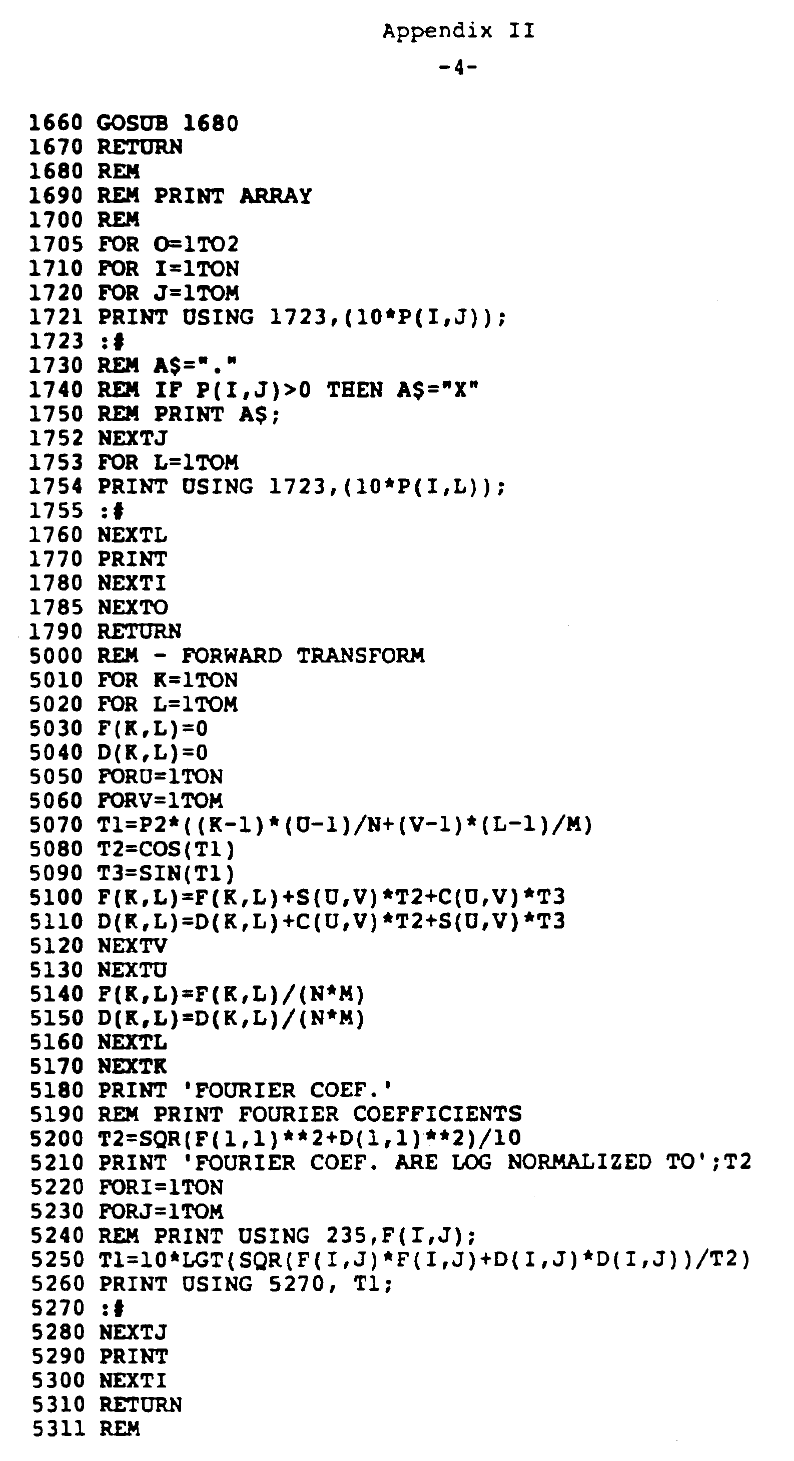

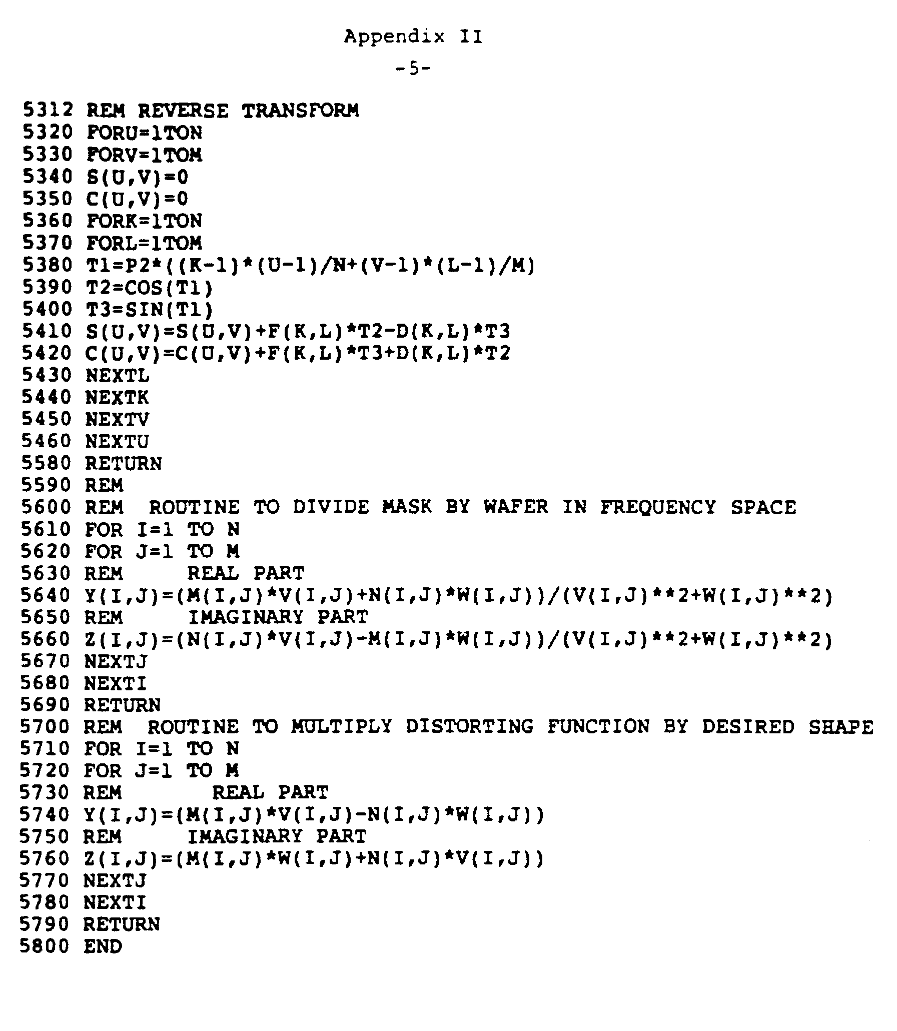

## Claims

1. A method for manufacturing a semiconductor circuit according to a design, comprising:
formulating the design into a form which a computer (11) can read;
using the computer (11) to convolve the design with an inverse distortion function (13) to obtain a convolved design;
converting said convolved design into a computer medium;
using the computer medium to obtain a mask (16) having a pattern representative of the convolved design;
applying a radiation-sensitive material according to the pattern on the mask (16); and
selectively removing said radiation-sensitive material according to the exposure of the radiation-sensitive material.

2. The method of claim 1 further comprising the steps of:
deriving the inverse distortion function by generating a first wafer pattern on a wafer from a first mask pattern and comparing the first wafer pattern to the first mask pattern.

3. A method for preparing a computer medium for the manufacture of a mask (16) for use in a semiconductor manufacturing process, comprising:
preparing a design in a form which can be read by a computer (11);
using a computer (11) to convolve the design with an inverse distortion function (12) to produce a convolved design; and
converting the convolved design to the computer medium;
whereby the convolved design is contained in the computer medium from which the mask (16) can be made.

## Patentansprüche

1. Verfahren zur Herstellung eines Halbleiterschaltkreises gemäß einem Design, das aufweist:
Darstellung des Designs in einer Form, die ein Computer (11) lesen kann;
Verwendung des Computers (11), um das Design mit einer inversen Verzeichnungsfunktion (13) zu überlagern, um ein überlagertes Design zu erhalten;
Konvertieren des überlagerten Designs in ein Computermedium;
Verwendung des Computermediums, um eine Maske (16) zu erhalten, die ein Muster besitzt, das für das überlagerte Design repräsentativ ist;
Aufbringung eines strahlungsempfindlichen Materials gemäß dem Muster auf der Maske (16); und
selektives Entfernen des strahlungsempfindlichen Materials gemäß der Belichtung des strahlungsempfindlichen Materials.

2. Verfahren nach Anspruch 1, das weiterhin die Schritte aufweist:
Ableiten der inversen Verzeichnungsfunktion durch Erzeugung eines ersten Wafermusters auf einem Wafer von einem ersten Maskenmuster und Vergleich des ersten Wafermusters mit dem ersten Maskenmuster.

3. Verfahren zur Vorbereitung eines Computermediums für die Herstellung einer Maske (16) zur Verwendung in einem Halbleiterfertigungsprozeß, das aufweist:
Vorbereiten eines Designs in einer Form, die durch einen Computer (11) gelesen werden kann;
Verwendung eines Computers (11), um das Design mit einer inversen Verzeichnungsfunktion (12) zu überlagern, um ein überlagertes Design zu produzieren; und
Konvertieren des überlagerten Designs zu dem Computermedium;
wodurch das überlagerte Design in dem Computermedium enthalten wird, von dem die Maske (16) hergestellt werden kann.

## Revendications

1. Procédé de fabrication d'un circuit à semiconducteur selon une conception, comprenant :
la formulation de la conception selon une forme qu'un ordinateur (11) peut lire ;
l'utilisation de l'ordinateur (11) pour réaliser une convolution de la conception avec une fonction de distorsion inverse (13) pour obtenir une conception ayant subi une convolution ;
la conversion de ladite conception ayant subi une convolution en un support d'information d'ordinateur ;
l'utilisation du support d'information d'ordinateur pour obtenir un masque (16) présentant un motif représentatif de la conception ayant subi une convolution ;
l'application d'un matériau sensible au rayonnement conformément au motif sur le masque (16) ; et
l'enlèvement sélectif dudit matériau sensible au rayonnement conformément à l'exposition dudit matériau sensible au rayonnement.

2. Procédé selon la revendication 1, comprenant en outre les étapes de :
dérivation de la fonction de distorsion inverse en générant un premier motif de plaquette sur une plaquette à partir d'un premier motif de masque et en comparant le premier motif de plaquette au premier motif de masque.

3. Procédé de préparation d'un support d'information d'ordinateur pour la fabrication d'un masque (16) destiné à une utilisation lors d'un processus de fabrication de semiconducteur, comprenant :
la préparation d'une conception selon une forme qui peut être lue par un ordinateur (11) ;
l'utilisation d'un ordinateur (11) pour réaliser une convolution de la conception avec une fonction de distorsion inverse (12) pour produire une conception ayant subi une convolution ; et
la conversion de la conception ayant subi une convolution en le support d'information d'ordinateur ;
de telle sorte que la conception ayant subi une convolution soit contenue dans le support d'information d'ordinateur à partir duquel le masque (16) peut être réalisé.
